# EUROPEAN PATENT SPECIFICATION

(11) **EP 3 809 807 B1**
(45) Date of publication and mention of the grant of the patent: **24.07.2024**
(21) Application number: 19204075.6
(22) Date of filing: 18.10.2019
(51) Int. Cl.: H05K 3/34

(54) **MANUFACTURING AND TAPE TRANSFER METHOD FOR A PATTERNED PREFORM**
HERSTELLUNG UND BANDÜBERTRAGUNGSVERFAHREN FÜR EINE STRUKTURIERTE VORFORM
PROCÉDÉ DE FABRICATION ET DE TRANSFERT DE BANDE POUR UNE PRÉFORME À MOTIFS

(43) Date of publication of application: 21.04.2021
(73) Proprietor: Heraeus Materials Singapore Pte. Ltd., 569881 Singapore (SG)
(72) Inventor: WONG, Chin Yeung, 569871 SINGAPORE (SG); BALASUBRAMANIAN, Senthil Kumar, 569871 SINGAPORE (SG); MAO, YanDa, 569871 SINGAPORE (SG); YAM, Lip Huei, 569871 SINGAPORE (SG); AGALA, Joel, 569871 SINGAPORE (SG); LO, Yee Ting, 569871 SINGAPORE (SG); PAN, Wei Chih, 569871 SINGAPORE (SG); SARANGAPANI, Murali, 569871 SINGAPORE (SG)
(74) Representative: Maiwald GmbH

(56) References cited:
- US-A- 5 762 259
- US-A1- 2003 036 255
- US-A1- 2010 147 928

## Description

### FIELD OF THE INVENTION

The invention relates to a manufacturing method for a patterned preform to be used as a transfer tape and such a patterned preform. The manufacturing method can relate to the technical field of electroconductive materials e.g. such as solder or sinter materials for connecting electronic components. The manufacturing method is especially suited to enable high precision and fine pitch applications with micron, sub-micron and nanometer sized inter-gap distances between two adjacent printed solder bumps.

### BACKGROUND OF THE INVENTION

Solder paste printing technology is moving to fine pitch stencil printing with small inter-gap distances between two adjacent printed solder bumps in e.g. mini & micro-LED applications. Still smaller inter-gap distances challenge present stencil solder printing paste technology with respect to powder size and precision printing to avoid electrical terminal shorting due to bridging of very close adjacent solder bumps.

US 5 762 259 A discloses solder bumps formed on a substrate using a screen printing and reflow operation. Solder paste is screened into openings of a stencil. The paste is reflowed within the stencil to produce a solder preform. The stencil and solder preforms are then aligned over the substrate to be bumped so that the preform aligns with a metal pad on the substrate. The solder preforms are again reflowed, and the solder within the openings of the stencil is drawn onto the metal pad.

US 2010/0147928 A1 discloses a process for a rework of bottom terminated leadless devices as well as a pair of stencils for the manual reattachment of such devices. This process is used to remount these devices once they have been removed from the printed circuit board or placing new devices on an already populated PCB. It is also used to add bumps to the bottom side of an electronic device package or pads.

US 2003/0036255 A1 discloses metal bumps formed by using a bump material containing a metal material which melts only partially at a first temperature and melts entirely at a second temperature higher than the first temperature. A resin film is formed on a surface of a substrate provided with electrodes, openings are formed in the resin film for exposing the electrodes, and the bump material is loaded into the openings. The bump material is heated to the first temperature for melting only part of the metal material, followed by cooling the bump material below the first temperature. After removing the resin film, the bump material is heated to the second temperature for entirely melting the metal material.

### SUMMARY OF THE INVENTION

Hence, there is a need to provide an improved manufacturing method, which allows still finer applications with even smaller inter-gap distances compared to the prior art.

The problem of the present invention is solved by the subject-matter of the independent claims, wherein further embodiments are incorporated in the dependent claims. It should be noted that the aspects of the invention described in the following apply to the patterned preform, the manufacturing method for a patterned preform as well as the tape transfer process of the patterned preform. The invention is set out in the appended set of claims.

According to the present invention, a manufacturing method according to clam 1 is presented.

The patterned preform obtained by the manufacturing method steps is used as a patterned transfer tape. In other words, the rigid base and the tape are used as transportation carrier for the electroconductive material, which is held by the rigid base and the tape. The patterned transfer tape may then allow a transfer or transport of the electroconductive material to a distinct position (e.g. a customer) and a further processing or an application of the electroconductive material on a customer's substrate as explained in the following. The patterned preform is taken and laid on the actual substrate (e.g. a substrate provided by the customer for LED attachment) in a reversed position (flipped), in which the electroconductive material faces the substrate and the tape faces away from the surface of the substrate. The rigid base and the tape are removed, so that only the electroconductive material remains on the e.g. LED substrate to provide attachment portions for e.g. an LED component. Thus, the manufacturing method further comprises the steps of:
c) Putting the patterned preform on a substrate (e.g. by flipping the patterned preform (transfer tape) in a reversed position)
d) Removing the rigid base and the tape, so that electroconductive material portions remain on the substrate to provide attachment portions for an electronic component.

The rigid base and/or the substrate might be a semiconductor grade panel or base out of a glass or polymer material, which endures e.g. temperatures of 150°C to 170°C. The glass material may comprise SiO₂. The polymer material may comprise polyamide, PMMS, polyphenylene sulfide (PPS), polyetherimide, polysulfones, liquid crystal polymers, polyether ether ketone, PET, polythiazide and/or the like.

The dimensions of the rigid base plate might be for example 5 mm to 1000 mm length and width and 1 mm to 100 mm thickness, preferably 5 mm to 500 mm length and width and 1 mm to 20 mm thickness.

The recesses might be any kind of channel, aperture or opening in any size or shape. The size may be several mm, µm or several nm. The shape may be round, circular, oval, angular, rectangular, polygonal or the like. The recesses might all be similar or different. The recesses might be open through holes, channels, blind holes or indentations. A depth of a recess might be 1 to 1000 µm, preferably 5 to 200 µm, which results in a thickness of a printed paste of 10 - 100 µm.

"Filling the recesses" in step b) might be understood as printing, dispensing or jetting of a paste form of the electroconductive material into the recesses or openings in the tape. The electroconductive material might be also applied as a powder into the recesses e.g. by dispensing eventually followed by a heating or otherwise compression step to increase the density and adhesion in between the powder particles.

The electroconductive material comprises a mixture of a first component and a second component with different melting points. The electroconductive material may further comprise a thermal and/or UV curing agent, a binder, a solvent, a dispersing agent, rheology modifier and/or the like as one of the first or second components or as additional component(s).

The manufacturing method according to the present invention is especially suitable for manufacturing high precision and fine pitch applications with micron, sub-micron and nanometer sized inter-gap distances. The inter-gap distance from a center of one printing dot or square to the closest adjacent printing dot or square may be in the range of nanometres to micrometres. Preferably, at least some of the inter-gap distances are less than 30 µm, preferably less than 20 µm, more preferably less than 10 µm.

The manufacturing method according to the present invention allows manufacturing high precision and fine pitch applications with extremely small recesses in the tape and thereby extremely small connections points to an electronic component to be connected by the electroconductive material. In an example, at least some of the recesses in the tape have a diameter or dimension or size in a range of micrometers to nanometers. Preferably, at least some of the recesses have a width between 10 µm to 100 µm, depending on customer substrate design, or a width of less than 25 µm, preferably less than 18 µm, more preferably less than 10 µm.

Additionally, the manufacturing method according to the present invention avoids non-uniform material deposition in form of different height and/or composition of the electroconductive material and helps to improve the manufacturing throughput and quality.

The fine pitch applications to be manufactured by the method according to the present invention might be mini or micro LED applications, semiconductor back-end packaging applications, surface mount interconnect applications and the like.

In an embodiment of the present invention, the method of manufacturing further comprises step a) comprising the steps of:
- providing a rigid base,
- at least partially covering the rigid base with a tape, and
- providing a pattern of recesses in the tape.

The tape may be applied to the rigid base by e.g. mechanical rolling eventually using a glue. The tape might be fixed to the rigid base.

In a further embodiment, step a) further comprises the step of providing an intermediate coating between the rigid base and the tape. The intermediate coating may protect the patterned tape from moisture, dust, chemicals, airborne contaminants, temperature extremes and the like. The intermediate coating may ease a removal of the tape from the rigid base. The intermediate coating might be a conformal coating, which means a protective coating or polymer film of e.g. 1-25 µm thickness, preferably 1-5 µm thickness, that 'conforms' to the base plate topology. The material composition of the intermediate coating may depend on the rigid base material. For a glass panel as rigid base, the coating could be a nitrate or oxide film. For a polymer base as rigid base, the coating could be a polymer, e.g. like polyurethane, silicones, acrylic, fluorinated or non-fluorinated - poly-para-xylylene (parylene), epoxy, amorphous fluoropolymer and/or the like. The intermediate coating can be applied e.g. by spraying, dispensing or spin coating.

In another example, but not part of the claimed invention, step a) of providing a patterned tape comprises the steps of (not necessarily all of them or in this order):
- providing a base or silicon wafer,
- applying a mask on at least portions of the base,
- applying a coating at least in unmasked portions of the base,
- hardening the coating by, e.g., UV radiation,
- removing undesired portions of the mask,
- etching the base to receive portions of different thickness depending on the masked and/or etched portions,
- casting a film, preferably out of or comprising poly dimethyl siloxane, on the etched base,
- removing the etched base, the tape now provides a negative shape of the base and comprises recesses analogue to the portions of different thickness of the base obtained by the earlier etching,
- applying the tape on a rigid base made, e.g., of glass, and
- joining the rigid base and the tape by, e.g. plasma or by an adhesive film or the like.

The polyimide or poly dimethyl siloxane tape is patterned and a creation of a recess pattern in the tape can be done by photolithography, chemical etching (wet and dry), laser-cutting or the like.

In an example, step b) of least partially filling the recesses of the patterned tape by an electroconductive material further comprises a squeegee step to remove electroconductive material (e.g. excess paste) exceeding the recesses and/or to level the electroconductive material.

In an example, the manufacturing method further comprises a step of providing an inert film on top of the patterned tape and the filled recesses. The inert film may be layered onto the patterned tape and the filled recesses by e.g. spraying, gluing, mechanically rolling. The inert film might be an oxide film, an organic film, a thermoplastic, a sacrificing film or the like. The inert film may protect the patterned preform during handling and in particular during a transport to a customer. The inert film may be mechanically or otherwise removed, e.g. burnt off, when it is no longer needed and prior to the connection to the substrate. A thickness of the inert film may range from 1 µm to 2000 µm.

Step c) is the provision of the patterned preform on a substrate. It may comprise a treatment or spraying of a flux agent onto the substrate and/or preform to e.g. prevent oxidation and/or to improve tackiness and handling properties.

Step c) may comprise an e.g. optical alignment of the patterned preform relative to the substrate. This can be done e.g. by means of fiducials.

Step c) may comprise a partial reflow or first heating for a (pre-)fixation of the patterned preform to the substrate. In other words, in an example, there might be a further step after the patterned preform is laid on the substrate in step c). This step might be a first heating step before the rigid base and the tape is removed in step d). The partial reflow or first heating may be in a range of 100 to 190°C, preferably 150 to 175°C. The duration may be between 1 and 30 minutes.

In another example, but not part of the claimed invention, the patterned preform may be (prefixed to the substrate using a fixation agent that might be locally applied onto the preform or substrate such as e.g. a glue, a drop of solvent.

Step d) can be understood in that everything else besides the electroconductive material pattern is removed before an electronic component, e.g. a LED component, is attached to the electroconductive material. Step d) may also comprise a treatment or spraying of a flux agent to e.g. prevent oxidation. In other words, the manufacturing method may further comprise a step of providing a flux agent between the substrate, the patterned preform and/or the electronic component in or before step d).

Step d) may also comprise a heating for a (pre-)fixation of the electronic component to the electroconductive material pattern. Step d) may be followed by a soldering, second heating or reflow step to finally fix the electronic component to the electroconductive material pattern. The final reflow or second heating may be in a range of 200 to 300°C, preferably 220 to 270°C. The duration may be between 1 and 20 minutes.

The electroconductive material comprises a mixture of a first component and a second component with different melting points. The first and second component might be both metals, metal alloys, doped metals or doped metal alloys or they might be different in nature, e.g. one component might be a resin, solvent, dispersant. Preferably, it is a mixture of metals, metal alloys, doped metals or doped metal alloys e.g. solder alloys and/or solders in form of powders.

The different melting points allow above explained different heating or reflow steps to fulfil different functions. The first component has a first melting point and the second component has a second melting point. The second melting point may be higher than the first melting point. At the first, lower melting point, there is no or at least no full reaction or melting of the second component.

In an example, the first melting point is selected to enable a joint between the electroconductive material and the substrate. This can be understood in that the first component is configured or selected to have a melting point (here in referred to as first melting point), which is configured to enable a joint between the electroconductive material and the substrate, when the patterned preform is subjected to a temperature being equivalent or higher than the temperature of first melting point.

In an example, the second melting point is selected to enable a formation of a joint between the electroconductive material and the electronic component. This can be understood in that the second component is selected to have a melting point (here in referred to as second melting point), which is configured to enable a joint between electroconductive material and the electronic component, when the patterned preform is subjected to a temperature being equivalent or higher than the temperature of second melting point.

According to the invention, the second melting point is higher than the first melting point.

In an example, the second melting point is selected to enable a formation of one or more intermetallic phases at least between the first component and the second component. This can be understood in that the second component is selected to have a melting point (here in referred to as second melting point), which is configured to enable a formation of one or more intermetallic phases at least between the first component and the second component, when the patterned preform is subjected to a temperature being equivalent or higher than the temperature of second melting point.

In an example, the second melting point is also selected to enable one or more intermetallic phases between the first component and the electronic component and/or between the second component and the substrate. This can be understood in that the second component is selected to have a melting point (here in referred to as second melting point), which is configured to enable a formation of one or more intermetallic phases at least between the first component and the electronic component and/or between the second component and the substrate, when the patterned preform is subjected to a temperature being equivalent or higher than the temperature of second melting point.

In other words, the first melting point is selected to enable a joint between the electroconductive material and the substrate and the second melting point is selected to enable a strong connection between the electronic component and the substrate via the electroconductive material. The first joint can be a weak joint such as adhesion or can be stronger through a first formation of at least one intermetallic phase at least at the borders of different materials or components. The second melting point might further be selected to enable a strong connection between the electronic component and the substrate e.g. via intermetallic phase formations between the metallic components of the electroconductive material, the substrate and the electronic component. The joints within the electroconductive material and/or between the electroconductive material and the substrate and/or between the electroconductive material and the electronic component allows the rigid base and the tape to be removed without tearing apart the electroconductive material. The joints give structural integrity.

According to the invention, the first component of the electroconductive material comprises or is a BiSnAg alloy. The first, lower temperature component of the electroconductive material may have the alloy potential composition: Sn56Bi1Ag or the like with e.g. a melting range of 130 to 150°C. According to the invention, the second component of the electroconductive material comprises or is a SnAgCu alloy. The second, higher temperature component of the electroconductive material may have the alloy composition: Sn3Ag0.5Cu (=SAC305), Sn4Ag0.5Cu, Sn1Ag0.5Cu or the like with e.g. a melting range of 215 to 225°C.

The electroconductive material is preferably a mixture or paste of solder alloys or powders.

Relative to a total paste content, the content of the first, lower temperature component may be 1 to 10 wt% and the content of the second, higher temperature component may be 85 to 95 wt%. An exemplary paste composition may be 1 wt% Sn57Bi1Ag + 87wt% SAC305, which means 88wt% total metal content in the paste.

The electroconductive material may comprise T6 to T9 particles, which mean the following size distributions of particles diameters: T6: 80 % of the particles have diameters between 5-15 µm, T7: 80 % of the particles have diameters between 2-11 µm, T8: 80 % of the particles have diameters between 2-8 µm, T9: 80 % of the particles have diameters between 1-4 µm.

The electroconductive material may comprise further components such as e.g. additives, solvents, dispersants, rheology modifier etc.

According to the present invention, also a patterned preform according to claim 10 is presented.

The recesses might be any kind of channel or opening in any size or shape. The recesses might all be similar or different. The recesses might be through holes or blind holes. In an example, at least some of the recesses have a width of less than 25 µm, preferably less than 18 µm.

According to the invention, the second melting point is higher than the first melting point. The first component of the electroconductive material comprises or is a BiSnAg alloy. The second component of the electroconductive material comprises or is a SnAgCu alloy.

In an example, the patterned preform further comprises an intermediate, conformal coating between the rigid base and the tape. In an example, the patterned preform further comprises an inert sacrificing film on top of the patterned tape and the filled recesses.

The patterned preform may be used for mini or micro LED applications, semiconductor back-end packaging, surface mount inter-connections and the like. A width of the patterned preform may depend on customer substrate design and may be between 1 mm and 1000 mm or even larger.

It shall be understood that the patterned preform and the manufacturing method for a patterned preform according to the independent claims have similar and/or identical preferred embodiments, in particular, as defined in the dependent claims. It shall be understood further that a preferred embodiment of the invention can also be any combination of the dependent claims with the respective independent claim.

These and other aspects of the present invention will become apparent from and be elucidated with reference to the embodiments described hereinafter.

### BRIEF DESCRIPTION OF THE DRAWINGS

Exemplary embodiments of the invention will be described in the following with reference to the accompanying drawings:
Figures 1 to 5 show schematic drawings of an example of a manufacturing method for a patterned preform
Figures 6-10 show schematic drawings of an exemplary application of a patterned preform
Figures 11 to 16 show schematic drawings of an alternative to Figs. 1 to 3

### DETAILED DESCRIPTION OF EMBODIMENTS

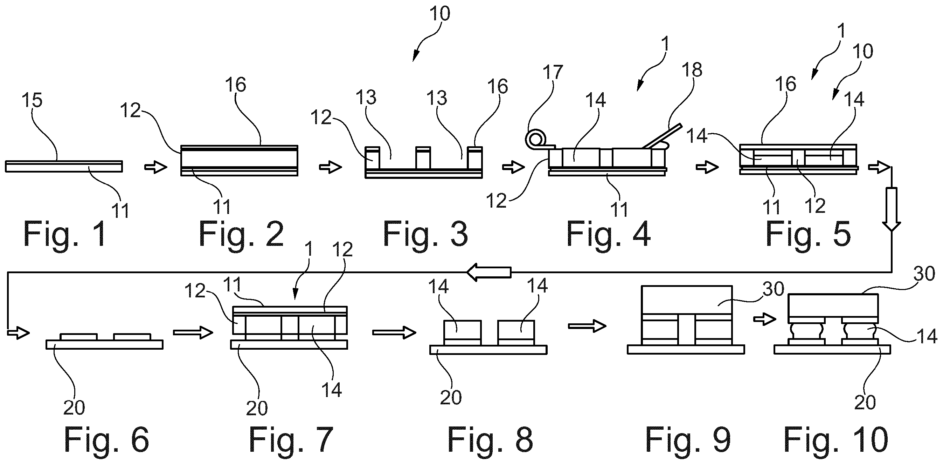

Figures 1 to 10 show schematically and exemplarily an embodiment of a manufacturing and application method for a patterned preform 1. The method comprises the following steps:
- Fig. 1): Providing a rigid base 11. Providing an intermediate coating 15 on the rigid base 11. The intermediate coating 15 may protect from moisture, chemicals, and the like.
- Fig. 2): Covering the rigid base 11 and the intermediate coating 15 with a tape 12. The tape is preferably made of or comprises polyimide or PDMS. The tape 12 is here applied to the rigid base 11 by e.g. mechanical rolling.
Providing an inert film 16 on top of the tape 12. The inert film 16 may be an oxide film, a thermoplastic, a sacrificing film or the like. It may be sprayed onto the tape 12.
- Fig. 3): Providing a pattern of recesses 13 in the tape 12 and the inert film 16 to obtain a patterned tape 10. The recesses 13 are here applied by photolithography. The recesses 13 are here blind holes. The size of a recess 13 may be several µm or several nm. Another inert film 16 may be sprayed into the recesses 13 and onto the patterned tape 10.
- Fig. 4): Filling the recesses 13 of the patterned tape 10 by an electroconductive material 14 to obtain the patterned preform 1. Filling the recesses 13 can be done by means of a solder paste printing or jetting nozzle 17 filling electroconductive material 14 into the recesses 13 in the tape 12..
The electroconductive material 14 comprises a mixture of a first component and a second component with different melting points. Preferably, both components are solder alloys. The different melting points allow different heating steps to have different functions. The first component of the electroconductive material 14 is here a BiSnAg alloy. The second component of the electroconductive material 14 is here a SnAgCu alloy.
Removing electroconductive material 14 exceeding the recesses 13 by means of a squeegee 18.
- Fig. 5): Providing an inert film 16 on top of the patterned tape 10 and the filled recesses 13. The inert film 16 may be an oxide film, a thermoplastic, a sacrificing film or the like. It may be sprayed onto the patterned tape 10 and the filled recesses 13. The inert film 16 may protect the patterned preform 1 during handling and in particular during a transport to a customer.
The patterned preform 1 obtained by above enlisted manufacturing method steps is used as a patterned transfer tape or, in other words, as transportation carrier for the electroconductive material 14, which is held by the rigid base 11 and the tape 12. The patterned transfer tape allows a transfer or transport of the electroconductive material 14 to e.g. a customer and a further processing or an application of the electroconductive material 14 on a customer's substrate 20 as explained in the following.
- Fig. 6): Providing a substrate 20. The substrate 20 is here provided by a customer for an LED attachment and/or semiconductor advanced packaging applications. A flux agent to e.g. prevent oxidation and/or to improve tackiness may be sprayed onto the substrate 20 or onto the surface of patterned preform.
- Fig. 7): Putting the patterned preform 1 on the substrate 20. The patterned preform 1 is taken and laid on the substrate 20 in a reversed position, in which the electroconductive material 14 faces the substrate 20 and the tape 12 faces the environment. The patterned preform 1 may be (optically) aligned relative to the substrate 20, e.g. by means of fiducials. The inert film 16 might be taken away prior to putting the patterned preform on the substrate.
There might be a partial reflow or first heating after the patterned preform 1 is laid on the substrate 20. It can be suitable for a pre-fixation of the patterned preform 1 to the substrate 20 and to ease a removal of the rigid base 11 and the tape 12 from the electroconductive material 14. The partial reflow may be in a range of 100 to 190°C for a duration between 1 and 30 minutes.
This first heat treatment allows the first component, e.g. BiSnAg particles, to melt. This will lead to an interconnection of the particles of the second component, e.g. SnAgCu, which are still stable as particles after this first heating treatment and will lead also to adhesion of the electroconductive material to the substrate. The particles of the second component will melt during a second heat treatment displayed in Fig. 9to form a stronger linkage between the first and second component of the electroconductive material 14 and the substrate.
- Fig. 8): Removing the rigid base 11, the tape 12 and all intermediate coatings and inert films, so that only electroconductive material portions remain on the substrate 20 to provide attachment portions for an electronic component 30. This can be understood in that everything else besides the electroconductive material 14 pattern is removed. There may also be a treatment with a flux agent to prevent oxidation.
- Fig. 9): Attaching the LED component 30 to the electroconductive material 14. Applying a second heating or reflow or soldering treatment for a fixation of the electronic component 30 to the electroconductive material pattern. The reflow may be in a range of 200 to 300°C for a duration between 1 and 30 minutes.
The electroconductive material 14 comprises a mixture of a first component and a second component with different melting points. The first melting point of the electroconductive material 14 may be selected to enable a joint between the electroconductive material 14 and the substrate 20 and the second melting point of the electroconductive material 14 may be selected to enable a joint between the electroconductive material 14 and the electronic component 30. Such joint can be understood as formation of one or more intermetallic phases at least at the borders of different materials or components. The second melting point might further be selected to enable one or more intermetallic phases at least between the first component and the second component. The second melting point may be also selected to enable one or more intermetallic phases between the first component and the electronic component 30 and/or between the second component and the substrate 20. The formation of intermetallic phase(s) may also lead to a nearly complete mixture and a homogeneous composition of the electroconductive material 14 situated between the electronic component and the substrate. The joints within the electroconductive material 14 and/or between the electroconductive material 14 and the substrate 20 allows the rigid base 11 and the tape 12 to be removed without tearing apart the electroconductive material 14.
- Fig. 10): Obtaining a product having the electronic component 30 fixed to electroconductive material 14 provided on the substrate 20.

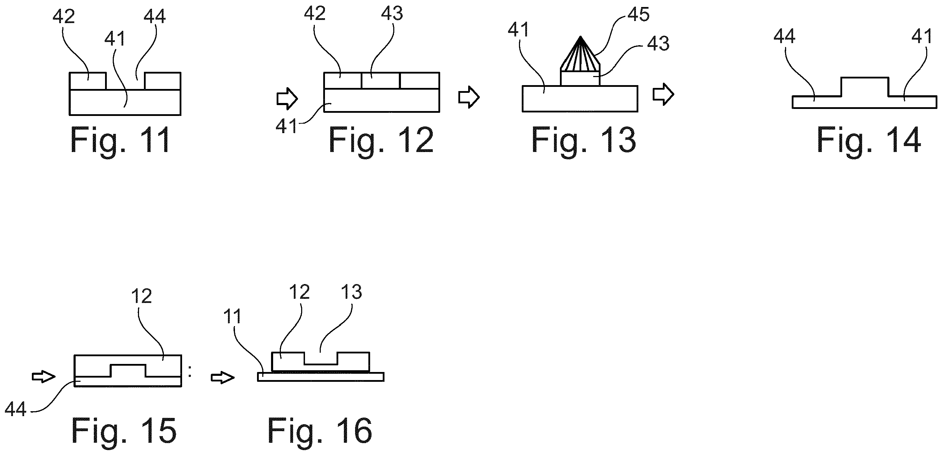

Figures 11 to 16 show schematically and exemplarily an alternative to Figs. 1 to 3 explained above. According to an illustrative example, but not belonging to the invention, this alternative can be followed by the method steps explained above in view of Figs. 4 to 10.
- Fig. 11): Providing a base or a silicon wafer 41. The thickness of the silicon wafer 41 may be in a range of 0.5 to 1.5 mm. Applying a mask 42 and in particular a photo mask on at least portions of the silicon wafer 41. The mask 42 is aligned relative to the silicon wafer 41. The thickness of mask 42 may be in a range of 5 to 15 µm. There are unmasked portions 44 or openings between masked portions of the silicon wafer 41.
- Fig. 12): Applying a coating 43 and in particular a photo-resist coating at least in the unmasked portions 44 or openings between masked portions of the silicon wafer 41.
- Fig. 13): Expose this sample to UV light 45 to harden the coating 43. Removing undesired portions of the mask prior or after the exposure to UV light.
- Fig. 14): Etching the silicon wafer 41 to obtain a silicon mold base 44. The coating protects areas of interest, which are thereby not etched. The etched silicon wafer 41 may still have portions with a maximum thickness in a range of 0.5 to 1.5 mm, but also etched and thereby reduced portions, which are reduced to or about a thickness in a range of 5 to 75 µm.
- Fig. 15): Applying a tape 12 or casting made of poly dimethyl siloxane on the etched silicon mold base 44. The tape 12 may cover the silicon mold base 44 to provide an even surface without essential differences in thickness of this sandwich.
- Fig. 16): Removing the silicon mold base 44. The tape 12 remains and now comprises recesses 13 or blind holes, which were formerly filled by the maximum thickness portions of the silicon wafer 41. Applying the tape 12 on a rigid base 11 made, e.g., of glass. Joining the rigid base 11 and the tape 12. This can be done by plasma or by an adhesive film or the like.

## Claims

1. A manufacturing method using a patterned preform (1), comprising the steps of:
- providing a patterned tape (10) comprising a rigid base (11) and a tape (12), wherein the tape (12) is made of polyimide or poly dimethyl siloxane, wherein the rigid base (11) is at least partially covered by the tape (12), and wherein the tape (12) comprises a pattern of recesses (13), and
- at least partially filling the recesses (13) of the patterned tape (12) by an electroconductive material (14) to obtain the patterned preform (1),
wherein the electroconductive material (14) comprises a mixture of a first component and a second component, wherein the first component comprises particles of a BiSnAg alloy with a first melting point and the second component comprises particles of a SnAgCu alloy with a second melting point,
wherein the second melting point is higher than the first melting point,
- putting the patterned preform (1) on a substrate (20),
- carrying out a first heating treatment to melt the particles of the first component while the particles of the second component remain stable as particles, the first heating treatment resulting in an interconnection of the particles of the second component and the adhesion of the electroconductive material (14) to the substrate, and
- removing at least the rigid base (11) and the tape (12), so that electroconductive material (14) portions remain on the substrate (20) to provide attachment portions for an electronic component (30).

2. Method according to claim 1, wherein the second melting point is also selected to enable one or more intermetallic phases between the first component and the second component, and preferably also between the first component and the electronic component (30) and/or between the second component and the substrate (20).

3. Method according claim 1 or 2, wherein the method further comprises the step of providing a flux agent between the substrate (20) and the patterned preform (1).

4. Manufacturing method according to one of the preceding claims, wherein at least some of the recesses (13) in the tape (12) have a width of less than 25 µm, preferably less than 18 µm.

5. Manufacturing method according to one of the preceding claims, wherein the step of providing a patterned tape (10) comprises the steps of:
- providing a rigid base (11),
- at least partially covering the rigid base (11) with a tape (12), and
- providing a pattern of recesses (13) in the tape (12).

6. Manufacturing method according to the preceding claim, wherein the step of providing a patterned tape (10) further comprises the step of providing an intermediate coating (15) between the rigid base (11) and the tape (12).

7. Manufacturing method according to one of the preceding claims, wherein the step of providing a patterned tape (10) further comprises the step of creating the pattern of recesses (13) in the tape (12) by chemical etching or laser-cutting.

8. Manufacturing method according to one of the preceding claims, wherein the manufacturing method further comprises a squeegee step to remove electroconductive material (14) exceeding the recesses (13).

9. Manufacturing method according to one of the preceding claims, further comprising a step of providing an inert film (16) on top of the patterned tape (10) and the filled recesses (13).

10. A patterned preform (1), comprising:
- a patterned tape (10) comprising a rigid base (11) and a tape (12), wherein the tape (12) is made of polyimide or poly dimethyl siloxane, wherein the rigid base (11) is at least partially covered by the tape (12), and
- a pattern of recesses (13) provided in the tape (12), wherein the recesses (13) of the patterned tape (10) are at least partially filled by an electroconductive material (14) to obtain the patterned preform (1),
wherein the electroconductive material (14) comprises a mixture of a first component and a second component, wherein the first component comprises particles of a BiSnAg alloy with a first melting point and the second component comprises particles of a SnAgCu with a second melting point,
wherein the second melting point is higher than the first melting point, wherein the electroconductive material (14) at least partially filling the recesses (13) is suitable for being adhered to a substrate (20) and for subsequently attaching an electronic component (30) according to the method of claim 1.

11. Patterned preform (1) according to the preceding claim, wherein at least some of the recesses (13) have a width of less than 25 µm, preferably less than 18 µm.

## Patentansprüche

1. Herstellungsverfahren unter Verwendung einer gemusterten Vorform (1), umfassend die Schritte:
- Bereitstellen eines gemusterten Bands (10), umfassend eine starre Basis (11) und ein Band (12), wobei das Band (12) aus Polyimid oder Polydimethylsiloxan besteht, wobei die starre Basis (11) mindestens teilweise durch das Band (12) bedeckt ist, und wobei das Band (12) ein Muster aus Vertiefungen (13) umfasst, und
- mindestens teilweises Füllen der Vertiefungen (13) des gemusterten Bands (12) durch ein elektrisch leitfähiges Material (14), um die gemusterte Vorform (1) zu erhalten, wobei das elektrisch leitfähige Material (14) eine Mischung aus einer ersten Komponente und einer zweiten Komponente umfasst, wobei die erste Komponente Partikel einer BiSnAg-Legierung mit einem ersten Schmelzpunkt umfasst und die zweite Komponente Partikel einer SnAgCu-Legierung mit einem zweiten Schmelzpunkt umfasst,
- wobei der zweite Schmelzpunkt höher als der erste Schmelzpunkt ist,
- Aufbringen der gemusterten Vorform (1) auf ein Substrat (20),
- Durchführen einer ersten Wärmebehandlung, um die Partikel der ersten Komponente zu schmelzen, während die Partikel der zweiten Komponente als Partikel stabil bleiben, wobei die erste Wärmebehandlung in einer Verbindung der Partikel der zweiten Komponente und der Klebung des elektrisch leitfähigen Materials (14) an das Substrat resultiert, und
- Entfernen mindestens der starren Basis (11) und des Bands (12), sodass Abschnitte des elektrisch leitfähigem Materials (14) auf dem Substrat (20) bleiben, um Befestigungsabschnitte für eine elektronische Komponente (30) bereitzustellen.

2. Verfahren nach Anspruch 1, wobei der zweite Schmelzpunkt ebenso ausgewählt wird, um eine oder mehrere intermetallische Phasen zwischen der ersten Komponente und der zweiten Komponente und vorzugsweise ebenso zwischen der ersten Komponente und der elektronischen Komponente (30) und/oder zwischen der zweiten Komponente und dem Substrat (20) zu ermöglichen.

3. Verfahren nach Anspruch 1 oder 2, wobei das Verfahren ferner den Schritt des Bereitstellens eines Flussmittels zwischen dem Substrat (20) und der gemusterten Vorform (1) umfasst.

4. Herstellungsverfahren nach einem der vorstehenden Ansprüche, wobei mindestens einige der Vertiefungen (13) in dem Band (12) eine Breite von weniger als 25 µm, vorzugsweise weniger als 18 µm, aufweisen.

5. Herstellungsverfahren nach einem der vorstehenden Ansprüche, wobei der Schritt des Bereitstellens eines gemusterten Bands (10) die Schritte umfasst:
- Bereitstellen einer starren Basis (11),
- mindestens teilweises Bedecken der starren Basis (11) mit einem Band (12), und
- Bereitstellen eines Musters aus Vertiefungen (13) in dem Band (12).

6. Herstellungsverfahren nach dem vorstehenden Anspruch, wobei der Schritt des Bereitstellens eines gemusterten Bands (10) ferner den Schritt des Bereitstellens einer Zwischenbeschichtung (15) zwischen der starren Basis (11) und dem Band (12) umfasst.

7. Herstellungsverfahren nach einem der vorstehenden Ansprüche, wobei der Schritt des Bereitstellens eines gemusterten Bands (10) ferner den Schritt eines Erzeugens des Musters aus Vertiefungen (13) in dem Band (12) durch chemisches Ätzen oder Laserschneiden umfasst.

8. Herstellungsverfahren nach einem der vorstehenden Ansprüche, wobei das Herstellungsverfahren ferner einen Rakelschritt umfasst, um elektrisch leitfähiges Material (14) zu entfernen, das über die Vertiefungen (13) hinausgeht.

9. Herstellungsverfahren nach einem der vorstehenden Ansprüche, ferner umfassend einen Schritt des Bereitstellens eines inerten Films (16) auf das gemusterte Band (10) und die gefüllten Vertiefungen (13).

10. Gemusterte Vorform (1), umfassend:
- ein gemustertes Band (10), umfassend eine starre Basis (11) und ein Band (12), wobei das Band (12) aus Polyimid oder Polydimethylsiloxan besteht, wobei die starre Basis (11) mindestens teilweise durch das Band (12) bedeckt ist, und
- ein Muster aus Vertiefungen (13), die in dem Band (12) bereitgestellt sind, wobei die Vertiefungen (13) des gemusterten Bands (10) mindestens teilweise durch ein elektrisch leitfähiges Material (14) gefüllt sind, um die gemusterte Vorform (1) zu erhalten, wobei das elektrisch leitfähige Material (14) eine Mischung aus einer ersten Komponente und einer zweiten Komponente umfasst, wobei die erste Komponente Partikel einer BiSnAg-Legierung mit einem ersten Schmelzpunkt umfasst und die zweite Komponente Partikel einer SnAgCu mit einem zweiten Schmelzpunkt umfasst,
wobei der zweite Schmelzpunkt höher als der erste Schmelzpunkt ist, wobei das elektrisch leitfähige Material (14), das die Vertiefungen (13) mindestens teilweise füllt, zum Kleben auf ein Substrat (20) und zum anschließenden Anbringen einer elektronischen Komponente (30) gemäß dem Verfahren nach Anspruch 1 geeignet ist.

11. Gemusterte Vorform (1) nach dem vorstehenden Anspruch, wobei mindestens einige der Vertiefungen (13) eine Breite von weniger als 25 µm, vorzugsweise weniger als 18 µm, aufweisen.

## Revendications

1. Procédé de fabrication à l'aide d'une préforme à motifs (1), comprenant les étapes consistant à :
- fournir un ruban à motifs (10) comprenant une base rigide (11) et un ruban (12), dans lequel le ruban (12) est constitué de polyimide ou de polydiméthylsiloxane, dans lequel la base rigide (11) est au moins partiellement couverte par le ruban (12), et dans lequel le ruban (12) comprend un motif d'évidements (13), et
- remplir au moins partiellement les évidements (13) du ruban à motifs (12) par un matériau électroconducteur (14) pour obtenir la préforme à motifs (1), dans lequel le matériau électroconducteur (14) comprend un mélange d'un premier composant et d'un second composant, dans lequel le premier composant comprend des particules d'un alliage BiSnAg avec un premier point de fusion et le second composant comprend des particules d'un alliage SnAgCu avec un second point de fusion,
dans lequel le second point de fusion est supérieur au premier point de fusion,
- mettre la préforme à motifs (1) sur un substrat (20),
- réaliser un premier traitement thermique pour faire fondre les particules du premier composant alors que les particules du second composant restent stables en tant que particules, le premier traitement thermique résultant en une interconnexion des particules du second composant et l'adhérence du matériau électroconducteur (14) au substrat, et
- retirer au moins la base rigide (11) et le ruban (12), de sorte que des parties du matériau électroconducteur (14) restent sur le substrat (20) pour fournir des parties de fixation pour un composant électronique (30).

2. Procédé selon la revendication 1, dans lequel le second point de fusion est également choisi pour permettre une ou plusieurs phases intermétalliques entre le premier composant et le second composant, et de préférence également entre le premier composant et le composant électronique (30) et/ou entre le second composant et le substrat (20).

3. Procédé selon la revendication 1 ou 2, dans lequel le procédé comprend en outre l'étape de fourniture d'un agent fondant entre le substrat (20) et la préforme à motifs (1).

4. Procédé de fabrication selon l'une des revendications précédentes, dans lequel au moins certains des évidements (13) dans le ruban (12) ont une largeur inférieure à 25 µm, de préférence inférieure à 18 µm.

5. Procédé de fabrication selon l'une des revendications précédentes, dans lequel l'étape de fourniture d'un ruban à motifs (10) comprend les étapes consistant à :
- fournir une base rigide (11),
- couvrir au moins partiellement la base rigide (11) avec un ruban (12), et
- fournir un motif d'évidements (13) dans le ruban (12).

6. Procédé de fabrication selon la revendication précédente, dans lequel l'étape de fourniture d'un ruban à motifs (10) comprend en outre l'étape de fourniture d'un revêtement intermédiaire (15) entre la base rigide (11) et le ruban (12).

7. Procédé de fabrication selon l'une des revendications précédentes, dans lequel l'étape de fourniture d'un ruban à motifs (10) comprend en outre l'étape de création du motif d'évidements (13) dans le ruban (12) par gravure chimique ou découpe laser.

8. Procédé de fabrication selon l'une des revendications précédentes, dans lequel le procédé de fabrication comprend en outre une étape de raclage pour retirer du matériau électroconducteur (14) dépassant les évidements (13).

9. Procédé de fabrication selon l'une des revendications précédentes, comprenant en outre une étape de fourniture d'un film inerte (16) au-dessus du ruban à motifs (10) et des évidements (13) remplis.

10. Préforme à motifs (1), comprenant :
- un ruban à motifs (10) comprenant une base rigide (11) et un ruban (12), dans laquelle le ruban (12) est constitué de polyimide ou de polydiméthylsiloxane, dans laquelle la base rigide (11) est au moins partiellement couverte par le ruban (12), et
- un motif d'évidements (13) fourni dans le ruban (12), dans laquelle les évidements (13) du ruban à motifs (10) sont au moins partiellement remplis par un matériau électroconducteur (14) pour obtenir la préforme à motifs (1), dans laquelle le matériau électroconducteur (14) comprend un mélange d'un premier composant et d'un second composant, dans laquelle le premier composant comprend des particules d'un alliage BiSnAg avec un premier point de fusion et le second composant comprend des particules d'un SnAgCu avec un second point de fusion,
dans laquelle le second point de fusion est supérieur au premier point de fusion, dans laquelle le matériau électroconducteur (14) remplissant au moins partiellement les évidements (13) est approprié pour être fixé par adhérence à un substrat (20) et pour fixer ultérieurement un composant électronique (30) selon le procédé de la revendication 1.

11. Préforme à motifs (1) selon la revendication précédente, dans laquelle au moins certains des évidements (13) ont une largeur inférieure à 25 µm, de préférence inférieure à 18 µm.
